# EUROPÄISCHE PATENTANMELDUNG

(11) **EP 4 376 233 A1**
(43) Veröffentlichungstag der Anmeldung: **29.05.2024**
(21) Anmeldenummer: 23209336.9
(22) Anmeldetag: 13.11.2023
(51) Int. Cl.: H01R 35/02, G01D 11/24, G12B 9/00, H01H 9/02, H03K 17/945

(54) **ELEKTRISCHES ENDGERÄT, HERSTELLUNGSVERFAHREN UND JUSTIERUNGSVERFAHREN**

(30) Priorität: 25.11.2022 DE 102022131236
(71) Anmelder: Turck Holding GmbH, 58553 Halver (DE)
(72) Erfinder: Faber, Michael, 58762 Altena (DE); Löwen, Nikolaj, 42287 Wuppertal (DE)
(74) Vertreter: DTS Patent- und Rechtsanwälte Schnekenbühl und Partner mbB

(57) **Zusammenfassung**

Elektrisches Endgerät, umfassend ein mehrseitiges Gehäuse mit einem Grundelement, umfassend mindestens zwei Rückseiten und ein Kopfelement, welches als Erfassungs- und/oder Funktionselement ausgebildet ist und eine Erfassungs- und/oder Funktionsseite umfasst und ein Montageelement mit einem Montagekörper mit mindestens zwei Seitenflächen, einer Basisseite und einer Innenwand, zwei Rückseiten, wobei das Montageelement und/oder der Montagekörper über eine Drehlagereinheit, welche eine Drehachse aufweist, mit dem Grundelement verbunden ist, wobei das Grundelement um die Drehachse schwenkbar ist und
i) das Grundelement eine ein- oder mehrteilige Fußfläche aufweist und
ii) das Montageelement und/oder der Montagekörper eine ein- oder mehrteilige Auflagefläche aufweist,
wobei die Fußfläche und die Auflagefläche in einer Ruhelage des Grundelements mindestens mit einer Teilfläche aneinander anliegen und die mindestens eine Teilfläche eine theoretische Kontaktebene aufspannt, die gegenüber der Erfassungs- und/oder Funktionsseite und/oder einer Rückseite um einen Neigungswinkel geneigt ist, und wobei die Drehachse senkrecht zur theoretischen Kontaktebene, der Auflagefläche und/oder der Fußfläche ausgerichtet ist, wobei das Grundelement aus der Ruhelage in Richtung der Drehachse verschieblich und in eine Justierlage verbringbar ist und wobei die Drehlagereinheit ein Federelement umfasst und derart ausgebildet und gelagert ist, dass mittels des Federelements eine Federkraft auf die Fußfläche in Richtung der Anlagefläche und/oder der Kontaktebene wirkt.

## Beschreibung

Die vorliegende Erfindung betrifft ein elektrisches Endgerät nach dem Oberbegriff des Anspruchs 1, ein Herstellungsverfahren nach dem Oberbegriff des Anspruchs 11 und ein Justierungsverfahren für das Endgerät nach dem Oberbegriff des Anspruchs 15.

Dem Stand der Technik sind Halterungen für Sensoren oder sonstige endständige Geräte bekannt, die eine feste Orientierung des Sensors zur Halterung vorgeben oder verstellbar konstruiert sind.

Dabei ist wichtiges Merkmal solcher Sensoren und Endgeräte, dass sich die Position der aktiven Fläche, wie die Erfassungsseite, an die aktuellen Gegebenheiten im Feld anpassen lässt.

Beispielsweise offenbart die WO 2004/477246 A1 eine Halterung in Form eines Gehäuses zur Aufnahme eines elektrischen Sensors, der weiterhin eine Anzeigevorrichtung zur Anzeige verschiedener elektrischer Zustände aus unterschiedlichen Blickrichtungen aufweist. Bei diesem Gehäuse ist der Sensor in seiner Orientierung zum Gehäuse festgelegt, so dass das gesamte Gehäuse in der Orientierung verändert werden muss, wenn der Sensor eine Neuausrichtung erfahren soll.

Die DE 10147023 A1 schlägt hierzu eine Verbesserung vor, indem eine Befestigungsvorrichtung für Sensoren mit einem Gehäuse zur Aufnahme des Sensors ausgestattet ist, wobei eine separate Montageplatte zur Befestigung an einen Untergrund vorgesehen ist, so dass zwischen dem Gehäuse und der Montageplatte Befestigungsmittel zur lösbaren Befestigung des Gehäuses auf der Montageplatte vorgesehen sind. Hierdurch sind die Befestigungsmittel derart ausgebildet, dass die Ausrichtung des Gehäuses gegenüber der Montageplatte verstellbar ist. Die DE 10147023 A1 offenbart weiterhin, dass die Ausrichtung des Gehäuses gegenüber der Montageplatte stufenweise um jeweils 90° verstellbar sein kann.

Dieses Befestigungselement ist dem Grunde nach gut geeignet, unterschiedliche Ausrichtungen für ein elektrisches Endgerät zu ermöglichen, wobei eine leichtere Handhabung des Befestigungselementes und/oder des elektrischen Endgerätes nach wie vor wünschenswert wäre.

Es ist die Aufgabe der vorliegenden Erfindung, ein verbessertes Befestigungselement und ein verbessertes elektrisches Endgerät vorzuschlagen.

Diese Aufgabe wird erfindungsgemäß gelöst durch ein elektrisches Endgerät nach den Merkmalen des Anspruchs 1, ein Herstellungsverfahren nach den Merkmalen des Anspruchs 11 und ein Justierungsverfahren für das Endgerät nach den Merkmalen des Anspruchs 15. Vorteilhafte Ausgestaltungen sind in den jeweiligen, zugehörigen Unteransprüchen angegeben.

Demnach wird die Aufgabe gelöst durch ein elektrisches Endgerät, das ein mehrseitiges Gehäuse mit einem Grundelement und einem Montageelement umfasst. Das Grundelement weist mindestens zwei Rückseiten und ein Kopfelement auf, wobei das Kopfelement als Erfassungs- und/oder Funktionselement ausgebildet ist und eine Erfassungs- und/oder Funktionsseite umfasst. Das Montageelement weist mindestens einen Montagekörper mit mindestens zwei Seitenflächen, einer Basisseite und einer Innenwand sowie zwei Rückseiten auf. Hierbei sind das Montageelement und/oder der Montagekörper über eine Drehlagereinheit, welche eine Drehachse aufweist, mit dem Grundelement verbunden, wobei das Grundelement um die Drehachse schwenkbar ist.

Weiterhin weist
i) das Grundelement eine ein- oder mehrteilige Fußfläche auf und
ii) das Montageelement und/oder der Montagekörper eine ein- oder mehrteilige Auflagefläche auf, wobei Fußfläche und die Auflagefläche in einer Ruhelage des Grundelements mindestens mit einer Teilfläche aneinander anliegen und die mindestens eine Teilfläche eine theoretische Kontaktebene aufspannt, die gegenüber der Erfassungs- und/oder Funktionsseite und/oder einer Rückseite um einen Neigungswinkel geneigt ist, insbesondere um einen Neigungswinkel von 45° geneigt ist und wobei die Drehachse senkrecht zur theoretischen Kontaktebene, der Auflagefläche und/oder der Fußfläche ausgerichtet ist. Hierbei ist das Grundelement aus der Ruhelage in Richtung der Drehachse verschieblich und kann in eine Justierlage verbracht werden, wobei die Drehlagereinheit ein Federelement umfasst und derart ausgebildet und gelagert ist, dass mittels des Federelementes eine Federkraft auf die Fußfläche in Richtung der Anlagefläche und/oder der Kontaktebene wirkt.

Anders ausgedrückt, wird das Grundelement vom Montageelement aus der Ruhelage abgehoben, so dass die Fußfläche des Grundelements von der Auflagefläche des Montageelementes bzw. dem Montagekörper beabstandet ist, was die Justierlage darstellt, in der das Grundelement um die Drehachse geschwenkt werden kann. Bei diesem Abheben und dem Halten in der Justierlage wirkt das Federelement mit einer rückstellenden Federkraft in Richtung der Ruhelage.

Es versteht sich für den Fachmann, dass das Endgerät in jeder Lage und Ausrichtung angebracht und betrieben werden kann und dass durch die Verschwenkung des Grundelements auf dem Montageelement auch nach der Montage des Montageelements und/oder des Montagekörpers die Ausrichtung mindestens des Grundelementes verändert werden kann. Somit sollen alle Angaben, die eine Orientierung des Endgerätes oder Teilen hiervon implizieren, wie bspw. "Rückseite", "Seitenfläche", "oben", "unten" etc., der sprachlichen Darlegung dienen und sind nicht einschränkend zu verstehen, es sei denn, es wird ausdrücklich etwas Unterschiedliches ausgeführt.

Hierbei wird von einer übergeordneten Grundausrichtung (hierin auch "Längsausrichtung" genannt) des Endgeräts in einem kartesischen Koordinatensystem mit den Achsen x-y-z ausgegangen, bei dem eine Steckerachse parallel oder deckungsgleich mit der Hauptachse des Endgeräts parallel zur x-Achse verläuft und die Stirn- oder Funktionsseite des Kopfelements senkrecht oder im Wesentlichen senkrecht zu Hauptachse bzw. der Steckerachse steht. Hierbei stehen die Anschlussseite des Montageelements parallel oder im Wesentlichen parallel zu der Funktionsseite. Die Hauptachse wird dadurch definiert, dass diese senkrecht auf der Erfassung- oder Stirnseite des Kopfelementes steht.

Mit Blick auf die theoretische Kontaktebene bedeutet dies im Falle der Grundausrichtung des Endgerätes, dass die Stirnseite parallel zu den y-z-Achsen ausgerichtet ist, wobei die theoretische Kontaktebene parallel zur z-Achse und gegenüber der y-Achse um einen Neigungswinkel von insbesondere 45° geneigt ist. Hierbei steht die Drehachse senkrecht auf der theoretischen Kontaktebene.

Die Eckausrichtung des Endgerätes unterscheidet sich von der Grund- oder Längsausrichtung dadurch, dass die Steckerachse und die Hauptachse nicht parallel ausgerichtet sind.

Die Eckausrichtung ist insbesondere gegeben und nachstehend vorrangig gemeint, wenn die Erfassungs- oder Stirnseite parallel zur x-z-Achse ausgerichtet ist und/oder senkrecht zur Anschlussseite ausgerichtet ist.

Der Neigungswinkel der Auflagefläche korreliert mit der gewünschten Ausrichtung und Anzahl an Ausrichtungen des elektrischen Endgerätes und ist grundsätzlich nicht eingeschränkt. Bei den üblichen vertikalen Tragelementen ist es vorteilhaft, wenn der Neigungswinkel 45° oder einen ganzzahligen Bruchteil hiervon beträgt, wie bspw. 45°/2 oder 45°/3, so dass u.a. in einer Drehwinkelstellung eine zu 90° veränderte Ausrichtung von einer ersten Ruhelage in eine zweite Ruhelage des elektrischen Endgerätes erreichbar ist.

Vorteilhafterweise weist der Montagekörper mindestens ein Befestigungselemente auf, insbesondere mehrere Befestigungselemente, womit der Montagekörper an einem Tragelement befestigt werden kann.

Das Montageelement und das elektrische Endgerät sind grundsätzlich an jeder Art von Tragelement anbringbar, sodass "Tragelement" nicht einschränkend zu verstehen ist und insbesondere eine Wand, ein Träger, eine Stütze, ein Haltearm und/oder ein sonstiges, tragendes und/oder stützendes Bauteil sein kann.

Unter einem Befestigungselement soll vorliegend insbesondere jedes Element verstanden werden, welches ein Befestigungsmittel, wie bspw. eine Schraube aufnehmen, führen und/oder halten kann. Ein Befestigungselement ist vorliegend insbesondere eine Öse, eine Bohrung und/oder ein Muttergewinde, insbesondere eine beidseitig offene Öse, Bohrung und/oder Muttergewinde.

Insbesondere kann es vorteilhaft sein, wenn das Befestigungselement eine Durchgangsbohrung, Durchgangsmutter, ein Muttergewindeabschnitt oder eine Durchgangsöse ist. Auf diese Weise erfolgt bei der Befestigung der Montageelemente auf oder an einem Tragelement auch für das Endgerät eine finale, dauerhafte Festlegung relativ zu dem Montageelement.

Das Endgerät ist vorteilhafterweise quaderförmig und insbesondere würfelförmig oder weitestgehend würfelförmig dimensioniert.

Eine weitere Verbesserung besteht darin, dass die Befestigungselemente mindestens zwei Paare von parallelen Befestigungselementen sind, wobei jeweils ein Paar paralleler Befestigungselemente zu dem anderen Paar an parallelen Befestigungselementen senkrecht steht und wobei deren Achsen eine gemeinsame Ebene aufspannen. Hierbei stellen die Befestigungselemente insbesondere zwei Paare von Durchgangsbohrungen und/oder Durchgangsgewinde dar. Vorteilhafterweise sind die Abstände der Befestigungselemente beider Paar identisch oder weitgehend identisch, so dass die Anbringung des Endgerätes auf einem Tragelement in jeder 90°-Lage möglich ist, ohne Veränderungen am Tragelement und dortigen Befestigungselementen vornehmen zu müssen.

Die Rückseite des Grundelements kann ein- oder mehrteilig ausgebildet sein und bestimmt sich durch die Möglichkeit, unmittelbar gegenüber und/oder in Anlage an die Innenwand des Montageköpers verbringbar zu sein. Durch das Verschwenken des Grundkörpers kann die Rückseite mit der Grundseite des Montagekörpers eine gemeinsame (Außen-)Seite bilden oder gegenüber der Innenseite angeordnet sein oder an dieser mindestens teilflächig, berührend anliegen. Vorteilhafterweise wird bei einer Ausführungsform mindestens eine der Rückseiten teilweise aus einem Abschnitt des Grundelements und einem Abschnitt des Kopfelements gebildet.

Die Innenwand des Montagekörpers wird durch eine Wand oder Fläche gebildet, die in Richtung der Hauptachse der Anspruchsseite gegenüberliegt, insbesondere parallel oder im Wesentlichen parallel gegenüber liegt.

Bei einer vorteilhaften Ausführungsform ist das Kopfelement und/oder Grundelement jeweils monolithisch ausgebildet, insbesondere aus einem Gusswerkstoff, wie einem Kunststoff oder einem Metallguss ausgebildet. Hiervon ausgenommen sind die elektrischen Bauteile und zugehörige Trägerelemente, wie eine Leiterplatte und Dicht- und/oder Verbindungselemente. Bei einer vorteilhaften Ausführungsform ist mindestens ein Teil der Drehlagereinheit auf ein Teilabschnitt des Grundelements oder des Montagekörpers, insbesondere ist es vorteilhaft, wenn ein Teil des Drehlagerelements als ein monolithischer Teil des Grundelements und ein Teil des Drehlagerelements als ein monolithischer Teil des Montagekörpers ausgebildet ist.

Vorliegend meint "monolithisch", dass die genannten Teile oder Komponenten ein einziges, in einer einzigen Form gegossenes Element bilden oder aus einem einzigen Vollmaterial durch Materialabtrag gebildet worden sind.

Vorteilhafterweise bilden das Kopfelement und das Grundelement eine Baueinheit mit einem im Wesentlichen gemeinsamen Innenraum aus dem Grundelementinnenraum und dem Kopfelementinnenraum. Vorteilhafterweise sind die elektrischen Bauteile und/oder deren Trägerelemente im Kopfelement befestigt, wobei diese in den Grundelementinnenraum hineinragen können.

Vorliegend ist "Auflagefläche" des Montageelements- oder -körpers nicht einschränkend als eine einzige durchgängige Fläche zu verstehen. Vielmehr soll unter "Auflagefläche" auch eine Mehrzahl von Teilflächen oder Flächenbereichen verstanden werden, auf oder an denen die "Fußfläche" des Grundelements in der Ruhelage anliegt. Die Teilflächen können bspw. Kantenflächen der Seitenwände und/oder gesonderte Auflageflächen sein. Das vorstehend Gesagte gilt in analoger Weise für die Fußfläche des Grundkörpers, weil die Anlagefläche des Montageelements und die kontaktierende Fußfläche des Grundkörpers als komplementäre Flächen die gemeinsame, theoretische Kontaktebene aufspannen.

Unter einer Justierlage soll vorliegend jede Position entlang der Drehachse außerhalb der Ruhelage verstanden werden, in der ein Verdrehen des Grundelements um die Drehachse möglich ist.

Insgesamt besteht das Endgerät in einer Art Bausatz aus einem Montageelement, Grundelement und aus einem Kopfelement. Das Grundelement besteht dabei mindestens aus einem Fußelement, das die Fußfläche als Teil seiner Unterseite aufweist. Vorteilhafterweise ist das Kopfelement in einer Art flachen Kappe oder flachen Schale ausgebildet, so dass beim Vergießen des Innenraums der Übergang von Kopfelement zum Grundelement bereits mit einem geringen Volumen an Vergussmaterial überdeckt und dauerhaft abgedichtet wird.

Dieses kleinste Vergussvolumen, das bei der optimalen Ausrichtung im Vergussschritt den Übergang überdeckt, beträgt gleich oder weniger als die 50 % des Innenraumvolumens, vorteilhafterweise gleich oder weniger als 30 % und idealerweise gleich oder weniger als 25 %. Hierbei wird zur Ermittlung des kleinsten Vergussvolumens das Volumen der elektrischen Bauteile nicht beachtet.

Analog zu der Anlagefläche und der Fußfläche ist "Seite", "Wand" oder "Seitenwand" nicht einschränkend zu verstehen und kann auch die genannten Elemente in einer mehrteiligen Form umfassen. Weiterhin können diese Unterbrechungen oder Öffnungen aufweisen, dreidimensional konturiert sein und/oder reliefartige Strukturen aufweisen.

Unter einem Endgerät soll vorliegend jegliches elektrisches Endgerät verstanden werden, insbesondere ein Endgerät, das als einfacher Sensor oder Aktor zur Überwachung oder Steuerung einer Fertigungs- oder Behandlungsanlage dient. Endgeräte sind somit insbesondere die folgenden Geräte:
- Sensoren, insbesondere Helligkeitssensoren, (induktive) Näherungsschalter;
- Aktoren, wie einfache Berührungsschalter, Pusher etc.;
- Emitter, insbesondere Strahlungs-/Lichtemitter, bspw. als Teil einer Lichtschranke, Schallemitter, bspw. als Teil einer Abstandssensorik oder
- Datenempfangs- oder -erfassungsgeräte, wie beispielsweise ein NFC-Empfangsgerät, RFID-(Schreib-)Lesekopf oder ein IR-Datenempfänger.

Das elektrische Endgerät, oder häufig verkürzt nur Endgerät genannt, umfasst die jeweils nötigen, typbedingten Bauteile und Komponenten als elektrische Bauteile, wie vorstehend teilweise bereits genannt. Die elektrischen Bauteile sind idealerweise in dem Kopfelement gehalten, bspw. als Teil einer gemeinsamen Trägerplatte.

Bei einer vorteilhaften Ausführungsform ist das Federelement eine Blatt- oder Spiralfeder, ein monolithisches Elastomer oder eine Mehrzahl von elastischen Fasern.

Hierbei ist das Federelement vorteilhafterweise als Zug- oder Druckfederelement ausgebildet und entsprechend an der Drehlagereinheit, dem Grundelement und/oder dem Montageelement an mindestens einer Stützeinheit abgestützt und/oder gelagert.

Wenn das Federelement als monolithisches Elastomer ausgebildet ist, kann ein Vorteil darin bestehen, dass an mindestens einem Ende einen Flanschabschnitt oder eine Verdickung angeordnet ist, welche zur Aufhängung oder Befestigung an einer Seite oder einer Stützeinheit der Drehlagereinheit dient. Eine vorteilhafte Ausführungsform besteht auch darin, dass das monolithische Elastomer als zylindrischer Körper bspw. aus einem gummielastischen Material gebildet ist.

Bei der Ausführungsform, bei der eine Mehrzahl von elastischen Fasern vorgesehen wird, kann es in analoger Weise vorteilhaft sein, wenn mind. ein Ende als Verdickung ausgebildet und/oder in einem Flansch oder Trägerkörper befestigt ist, so dass diese gemeinsam an mind. einer Seite oder einer Stützeinheit der Drehlagereinheit aufgehängt oder befestigt werden können.

Um das Endgerät vibrationsfrei zu befestigen und Geräuschemissionen zu verringern sowie zur Vermeidung einer unbeabsichtigten Verstellung der Drehlage, kann ein Vorteil darin bestehen, wenn das Federelement auch in der Ruhelage des Grundelements vorgespannt ist.

Bei einer verbesserten Ausführungsform kann vorgesehen sein, dass die Drehlagereinheit mindestens eine untere oder obere Stützeinheit für das Federelement umfasst. Hierdurch wird die Federkraft in der Justierlage oder unter Vorspannung in Kraftflussrichtung auf das Grundelement und/oder den Montagekörper übertragen.

Eine Verbesserung kann weiterhin darin bestehen, dass die Drehlagereinheit mindestens zwei, idealerweise genau zwei sich gegenüberliegende Stützeinheiten für das mindestens eine Federelement umfasst.

Hierbei ist vorteilhafterweise, wie vorstehend beschrieben, mind. eine Stützeinheit oder ein Element der Stützeinheit, wie ein Auflagering, um die Drehachse rotierbar. Der einseitig oder beidseitig vorgesehen Auflagering kann vorteilhafterweise aus einem Metall oder einem sehr harten Kunststoff, wie ein HDPE, Acrylglas oder Plexiglas ausgebildet sein.

Bei einer vorteilhaften Ausführungsform kann vorgesehen sein, dass die Drehlagereinheit einen Drehlagerbolzen umfasst, an welchem oder in welchem mindestens ein Federelement geführt wird. Idealerweise ist der Drehlagerbolzen Teil des Montagekörpers und wird von einem Drehlagerabschnitt des Grundelements auf einer Teilstrecke umschlossen. Hierbei kann der Drehlagerabschnitt von der Ruhelage in die Justierlage parallel entlang dem Drehlagerbolzen in Richtung der Drehachse verschoben werden.

Vorteilhafterweise weist der Drehlagerabschnitt einen nach innen weisenden, flanschartigen Lagerabschnitt auf und der Drehlagerbolzen an dem unteren, nicht freien Ende eine komplementäre Auflagekante auf. In der Ruhelage wird der Lagerabschnitt des Drehlagerabschnitts auf die Auflagekante des Drehlagerbolzens durch die Federkraft angedrückt bzw. im Justierschritt hiervon abgehoben.

Um einen staub- und/oder gasdichte Verschluss des Gehäuseinnenraums zu realisieren, kann eine weiter Verbesserung darin bestehen, dass auf der Auflagekante ein umlaufendes Dichtelement, wie bspw. ein O-Ring, angeordnet ist. Alternativ oder zusätzlich kann der Drehlagerabschnitt sich in Richtung des Fußes des Drehlagerbolzens erstrecken, wobei an der Unterkante des Drehlagerabschnitts und/oder am Übergang von dem Drehlagerbolzen tragenden Wandabschnitt ein umlaufendes Dichtelement angeordnet ist.

An dem freien Ende des Drehlagerbolzens ist vorteilhafterweise eine ober Stützeinheit angeordnet, die insbesondere eine Schraube oder ein Stopfen sein kann und vorteilhafterweise einen den Drehlagerbolzen überkragenden Kranz- oder Flanschabschnitt aufweist. Zwischen der oberen und der unteren Stützeinheit wird das Federelement eingeklemmt.

Es kann eine weitere Verbesserung darin bestehen, dass mindestens einseitig ein Auflagering, vorrangig ein metallischer Auflagering vorgesehen ist. Dieser kann beispielsweise auf dem flanschartigen Lagerabschnitt des Drehlagerabschnitts aufliegen, so dass beim Verdrehen des Grundelements im Justierschritt dieses auf dem Auflagering mit geringer Reibung gleiten kann oder der Auflagering gemeinsam mit dem Federelement verdreht werden kann.

Bei einer weiteren, verbesserten Ausführungsform ist eine durchgehende Schraube in einem hülsenartigen Drehlagerbolzen geführt, wobei der Schraubenkopf oder die konternde Mutter außen an der Grundseite und/oder einer dortigen Aussparung des den Drehlagerbolzen tragenden Wandabschnitts anliegt. Der Grundaufbau der Schraube, die die ober Stützeinheit bildet, ist analog ausgebildet.

Weiterhin kann ein Vorteil drin bestehen, dass mindestens ein Drehanschlag vorgesehen ist, um ein Überdrehung über ca. 360° zu unterbinden, um übergroßen Zug auf das innere Kabel oder einen inneren Steckverbinder zu verhindern. Hierzu kann am Montageköper, insbesondere im Bereich der unteren Stützeinheit ein Anschlag ausgebildet sein, der mit einem entsprechenden Gegenanschlag oder Bolzen im Grundelement zusammenwirkt. Alternativ kann eine Steuerkurve und eine zugehöriger Kulissenstein vorgesehen werden.

Eine verbesserte Ausführungsform kann gegeben sein, wenn das Montageelement an mindestens einer Seitenwand oder Seitenfläche und/oder Innenwand mindestens eine Sperrkontur aufweist, welche form- und/oder kraftschlüssig in der Ruhelage mit einer Sperrgegenkontur des Grundelements die Verdrehung des Grundelements um die Drehachse verhindert.

Die Sperrkontur kann ein abschnittsweiser Überstand an einer oder mehreren Kanten des Montagekörpers sein, die als kleine Nasen oder Überhänge ausgebildet sind. Die korrelierende Kante des Grundelements weist eine entsprechende Phase oder einen Radius auf. Somit muss auch im Falle, dass in der Ruhelage die Rückseite des Grundelements nicht an der Innenseite des Montagekörpers anliegt, erst die Justierlage gegen die Kraftrichtung des Federelementes hergestellt werden, bevor das Grundelement um die Drehachse verdreht werden kann.

Alternativ oder zusätzlich kann einseitig eine Nut oder Absatzkante und gegenüberliegend als entsprechende (korrelierende) Gegenkontur eine Feder oder Gegenkante angeordnet sein, die sich beispielsweise zu einer weitgehend durchgehenden Seitenwand ergänzt.

Bei einer vorteilhaften Ausführungsform haben die Auflagefläche und die Fußfläche mindestens abschnittsweise einen geschwungenen, welligen Verlauf, der sich komplementär ergänzt und/oder weisen sonstige formflüssige Geometrien als Sperrkontur auf, die sich ergänzen und zum Erreichen der Justierlage in axialer Richtung überwunden werden müssen, bevor das Verdrehen des Grundelements gegenüber dem Montageelement ermöglicht wird. Alternativ oder zusätzlich kann eine Sperrkontur auch in gesonderten Nut-Feder-Elementen, Zapfen-Aufnahmeelementen oder in sonstiger Weise realisiert sein, die jeweils das unmittelbare Verdrehen in der Ruhelage, ohne axiale Beabstandung von Auflagefläche und Fußfläche, verhindern.

Bei einer besonders vorteilhaften Ausführungsform weist die Auflagefläche eine äußere, umlaufende Erhöhung auf, wobei korrelierend hierzu die Fußfläche und/oder die Seitenfläche des Grundelements mindestens eine Aussparung aufweist. Die Erhöhung und die Aussparung fügen sich in der Ruhelage zu einer durchgängigen Seitenfläche zusammen, die insbesondere weitgehend durchgängig ist. Die Erhöhung bildet somit eine Sperrkontur, die vor dem Verdrehen in axialer Richtung überwunden werden muss. Bei einer alternativen Ausführungsform ist die Erhöhung nur streckenweise vorgesehen und/oder auf der Seite des Grundelements vorgesehen und die Aussparungen sind in analoger Weise auf dem Montageelement oder der Montagekörper angeordnet.

Bei einer verbesserten Ausführungsform kann vorgesehen sein, dass der Montagekörper eine erste Öffnung zur Durchführung eines Kabels von einem auf der Anschlussseite angeordneten Steckverbinder zum Grundelement aufweist. Alternativ oder zusätzlich kann eine weitere Verbesserung darin bestehen, dass der Montagekörper eine weiter Öffnung aufweist, in welcher der Steckverbinder und/oder ein Adapterkörper für einen Steckverbinder aufgenommen und fixiert werden kann. Idealerweise gehen die erste Öffnung und die weitere Öffnung ineinander über.

Vorteilhafterweise ist auf der Rückseite der Anschlussseite zwischen dem Grundelement ein Zwischenraum ausgebildet, in dem ein Abschnitt des vom Steckverbinder zum elektrischen Bauteil führenden Kabels aufnehmbar ist. Die erste und zweite (weitere) Öffnung führen idealerweise von der Anschlussseite in diesen Zwischenraum. Vorteilhafterweise wird der Zwischenraum gebildet durch mindestens einen Rücksprung im Gehäuseabschnitt des Grundelements und/oder des Montagekörpers.

Vorteilhafterweise ist die zweite Öffnung im Montagekörper als ein Rohrstutzen oder ein Hülsenabschnitt ausgebildet, der in Richtung der Hauptachse über den Montagekörper hinausragt. Dieser kann ein Rast- oder Kupplungselement aufweisen, in den ein Steckverbinder oder einer Adapterkörper für einen Steckverbinder eingerastet oder eingekuppelt werden kann.

Vorteilhafterweise ist der Rohrstutzen oder der Hülsenabschnitt mit dem Montagekörper monolithisch ausgebildet.

Hierbei kann die erste, innere Öffnung, die nur das Kabel aufnehmen bzw. hindurchleiten muss, einen kleineren Durchmesser aufweisen, als die zweite, äußere Öffnung, in der der Adapterkörper oder der Steckverbinder gehalten ist. Alternativ kann auch eine einzige, durchgehende Öffnung vorgesehen werden, mit nur einem einzigen Durchmesser.

Die äußere, zweite Öffnung kann dahingehende verbessert werden, dass diese ein (Innen- )Gewinde oder einen Bajonettverschluss aufweist, insb. zum Befestigen eines Steckeradapters, Steckverbinders bzw. von Teilen davon. Weiterhin kann diese zweite Öffnung im Montagekörper, die als Rohrstutzen oder ein Hülsenabschnitt ausgebildet ist, selbst als eine Seite eines Steckverbinders ausgebildet sein.

Bei einer weiter verbesserten Ausführungsform kann vorgesehen sein, dass das Grundelement und das Kopfelement miteinander verbunden oder verbindbar sind, wobei das Grundelement mindestens ein Kopplungselement umfasst, an welchem ein korrelierendes (Gegen-)Kopplungselement des Kopfelements form- und/oder kraftschlüssig verbindbar ist.

Die Kopplungselementen können insb. Haken, Klipps, Rastverbindung sein, die nach dem Aufsetzten der beiden Teile werkzeuglos geschlossen werden können und sich gegebenenfalls gegenseitig verriegelt, so dass diese nur noch zerstörend geöffnet oder getrennt werden können, auch wenn kein Vergussmaterial in diesem Bereich eingeführt wird, das anschließend aushärtet.

Alternativ können eine Verschraubung oder eine sonstige lösbare Verbindung vorgesehen werden.

Vorteilhafterweise bildet hierbei das Kopfelement den stirnseitigen Abschluss. Das Kopfelement stellt dabei den vorrangigen Funktionsraum für die elektrischen und elektrischen Bauteile zur Verfügung, wobei diese hierauf nicht beschränkt sind und in den gesamten Innenraum ragen können.

Bei einer weiteren, alternativen Ausführung ist das Kopfelement mit einer inneren Zwischenwand versehen, wobei ein oder mehrere Kabel zur Kommunikation und/oder Stromversorgung angeschlossen sind.

Bei einer weiteren Verbesserung dieser Ausführungsform kann vorgesehen sein, dass am Übergang zum Kopfelement ein Dichtelement angeordnet ist, insbesondere ein umlaufendes Dichtelement.

Das umlaufene Dichtelement ist insbesondere als Doppelringdichtung ausgebildet, beidseitig in einer Nut, die sowohl in der Oberkante des Grundelementes als auch in der Oberkante des Kopfelementes angeordnet ist.

Zur Komplettierung des Endgerätes als Baukastensystem, in dem unterschiedliche Typen von Endgeräten in identische oder im Wesentlichen identische Grund- und Kopfelemente eingefügt oder aus diesen gebildet werden können, ist es vorteilhaft, wenn die elektrischen Bauteile vollständig in dem Kopfelement gehalten werden. Hierzu kann das Kopfelement Klipps- oder Rastelemente aufweisen, insbesondere an zwei gegenüberliegenden Seiten Klipps- oder Rastelemente aufweisen, in welche eine Trägerplatte für die elektrischen Bauteile eingelegt und verklemmt werden kann.

Das Grundelement dient vorteilhafterweise nicht zu Befestigung von elektrischen Bauteilen oder einer Trägerplatte. Lediglich ein Kabel zur Verbindung datenleitender oder stromleitender Verbindung und/oder ein hierfür notwendiger, innerer Steckverbinder ist bei einer solchen Ausführungsform im Grundelement angeordnet.

Zur Anzeige von Betriebszuständen und/oder zu einer sonstigen Warn- und/Signalabgabe ist es vorteilhaft, wenn das Kopfelement ein oder mehrere LED aufweist. Die LED sind idealerweise in den Ecken des Kopfelements angeordnet. Auch wenn die LED im elektrischen Endgerät idealerweise in den Ecken des Kopfelements angeordnet sind, besteht eine Ausführungsvariante darin, mindestens eine LED in einer Ecke des Grundelements, insbesondere jeweils eine LED in mehreren Ecken des Grundelements vorzusehen. Weiterhin kann vorgesehen werden, dass mindestens eine LED in dem Stecker selbst integriert ist, um bspw. die Betriebszustände anzuzeigen.

Wenn die betroffene Kante als Gegenkante für eine Sperrgegenkontur zu einer Sperrkontur dient, ist es vorteilhaft, wenn die LED in einer analogen Sperrgegenkontur eingefügt oder als eine solche ausgeformt ist. Insgesamt ist es vorteilhaft, wenn mind. zwei LED vorgesehen werden, die unterschiedliche Farben emittieren können. Bei vier LED können bspw. zwei rote oder gelbe LED und zwei Grüne LED vorgesehen werden.

Bei einer weiteren, verbesserten Ausführungsform weist das Grundelement mindestens eine Vergussöffnungen auf. Besonders vorteilhaft ist es, wenn die mindestens eine Vergussöffnung auf einer der Rückseiten angeordnet ist, die in der Linear- oder Grundausrichtung der Stirnseite gegenüberliegt. Dies hat den Vorteil, dass zum Vergießen das Endgerät auf die Stirnseite vertikal nach unten ausgerichtet werden kann und das Vergussmaterial primär das Kopfelement, die dortigen elektrischen Bauteile und die Übergangsnaht- oder -dichtung vom Kopfelement zum Grundelement befüllt. Das Befüllen des Innenraums in Bereichen, in denen keine elektrischen Bauteile angeordnet sind, kann minimiert oder sogar vollständig vermieden werden.

Das Vergießen erfolgt vorteilhafterweise nur bis zu einem solchen Füllstand, dass das Federelement vollständig oder weitgehend frei von Vergussmaterial bleibt, um die Verstellmöglichkeit von einer ersten Ruhelage in eine Justierlage und von dort in eine zweite Ruhelage nicht zu eliminieren.

Insbesondere wenn es vorgesehen ist, dass das Grundelement vollständig mit einem Vergussmaterial ausgefüllt werden soll, kann es vorteilhaft sein, dass eine rohrförmige oder zylindrische Schutzkappe über dem freien Ende der Drehlagereinheit angeordnet wird. Eine derartige Schutzkappe besitz ein verschlossenes Ende und ein offenes Ende und ermöglicht, dass das Grundelement komplett vergossen werden kann, wobei das Federelement und damit die Federmechanik vergussfrei gehalten wird.

Vorteilhafterweise sitzt der Rand des offenen Endes der Schutzkappe dichtend auf dem Fußelement und/oder dem Drehlagerabschnitt des Grundelements auf. Bei einer vorteilhaften Ausführungsform ist die Schutzkappe mit dem Rand am offenen Ende aufgeklebt oder aufgeschweißt. Alternativ oder zusätzlich ist die Schutzkappe kraft- und/oder formschlüssig im Bereich des Fußelements und/oder dem Drehlagerabschnitt befestigt, wobei bedarfsweise geeignete Dichtelemente vorgesehen werden können. Vorgenannte Anbringung der Schutzkappe erfolgt vorteilhafterweise vor dem Vergussschritt des Grundelements.

Idealerweise sind zwei Vergussöffnungen vorgesehen, wobei eine zum Einfüllen dient und eine zum Entlüften. Nach dem Vergießen können die Vergussöffnungen verschlossen werden, insbesondere dauerhaft verschlossen werden. Dies kann durch einen Stopfen, Verkleben, Verschweißen oder sonst ein geeignetes Mittel oder Verfahren erfolgen.

Das Endgerät kann dahingehend weiter verbessert werden, dass ein Eingriffsfeld vorgesehen ist, das als lokaler Rücksprung ausgebildet ist. Dieser ist vorteilhafterweise im Bereich der Seitenflächen, die insbesondere vertikal zu der Anschlussseite des Montageelements stehen. Um das Grundelement von dem Montagekörper abheben zu können, überstreckt sich das Eingriffsfeld vorteilhafterweise über den Bereich der Seitenfläche des Grundelements und des Montagekörpers.

Von der Erfindung ist auch ein Herstellungsverfahren für ein elektrisches Endgerät betroffen, das die folgenden Schritte aufweist:
- Verbinden eines Montageelements mit einem Grundelement an einer gemeinsamen Drehlagereinheit, welche eine Drehachse umfasst, wobei die Drehlagereinheit weiterhin eine Federeinheit umfasst und/oder eine Federeinheit hiermit verbindbar ist und wobei
- in einem nachfolgenden Schritt die Federeinheit entlang der Drehachse derart gespannt wird, dass das Grundelement auf das Montageelement bzw. dessen Montagekörper gepresst wird und/oder auf das Montageelement gepresst wird, sobald das Grundelement vom Montageelement in Achsrichtung abgehoben oder abgezogen wird.

Bei diesen Schritten ist es vorteilhaft, wenn das Kopfelement noch nicht mit dem Grundelement verbunden ist oder lediglich das innere Kabel oder ein innerer Steckverbinder mit dem Kopfelement verbunden ist.

Dieses Verfahren kann dahingehend verbessert werden, dass das Kopfelement nachfolgend auf das Grundelement aufgebracht wird, insbesondere aufgepresst wird. Vorteilhafterweise wird das Kopfelement werkzeuglos aufgebracht, bspw. aufgeklippst oder eingerastet. "Werkzeuglos" meint vorliegend nicht ein Transport- oder Greifmittel, mit welchem das Kopfelement und/oder das Grundelement ergriffen, aufeinander zugeführt und aufeinander geschoben werden, als Ersatz und Automation eines grundsätzlich rein händisch durchführbaren Fertigungsschritts.

Vor dem werkzeuglosen Aufbringen des Kopfelements wird das vom (äußeren) Steckverbinder kommende innere Kabel an einer Leiterbahn des Trägerelements verlötet oder ein entsprechender innerer Steckverbinder zusammengefügt.

Bei einer verbesserten Verfahrensvariante wird der Innenraum des Kopfelements mindestens teilweise mit Vergussmaterial aufgefüllt. Hierzu kann es vorteilhaft sein, das elektrisches Endgerät vertikal derart auszurichten, dass das Kopfelement und/oder die Stirnseite des Kopfelements vertikal nach unten weist und nachfolgend, dass das Kopfelement durch mindestens eine (Verguss-)Öffnung im Grundelement hindurch mit Vergussmaterial aufgefüllt wird.

Vorteilhafterweise ist eine zweite Öffnung vorgesehen, durch welche die Luft aus dem Innenraum beim Einfüllen von Vergussmaterial entweichen kann. Der gemeinsame Innenraum aus dem Grundelementinnenraum und dem Kopfelementinnenraum wird vorteilhafterweise mindestens in dem Umfang aufgefüllt und anschließend ausgehärtet, bis alle elektrischen Bauteile überdeckt und auch der Übergang zwischen Grund- und Kopfelement sowie eine dortige Dichtung überdeckt sind.

Insgesamt ist es vorteilhaft, wenn mittels des Herstellungsverfahrens ein elektrisches Endgerät nach einem der hierin genannten Varianten und Ausführungsbeispiele hergestellt wird.

Weiterhin ist von der Erfindung auch ein Verfahren zur Justierung eines elektrischen Endgerätes umfasst, wobei das elektrisches Endgerät ein Grundelement und ein Montageelement umfasst, die sich miteinander in Teilflächen in gegenseitiger Anlage befinden, wobei in einem Justierschritt das Grundelement von einer Ruhelage in einer Linearausrichtung in eine zweite Ruhelage in einer Eckausrichtung und umgekehrt verbracht wird. Hierbei weist das Justierverfahren die folgenden Schritte auf:
- Das Grundelement wird aus der ersten Ruhelage in Richtung einer Drehachse um eine Strecke gegen eine anliegende Federkraft vom Montageelement abgehoben,
- das Grundelement wird um einen Winkelgrad um die Drehdrehachse gedreht, die der Ausrichtung der zweiten Ruhelage in der Drehrichtung entspricht,
- das Grundelement wird in Richtung der Federkraft und parallel zur Drehachse zurückgeführt und mit dem Montageelement in Anlage gebracht.

Hierbei wird bei einer Verfahrensvariante das Grundelement um die Strecke in Richtung der Drehachse gegen die Federkraft vom Montageelement abgehoben, die gleich oder größer als die Erstreckung einer vorliegenden Sperrkontur des Grundelements und/oder des Montageelements ist.

Vorteilhafterweise ist das Verfahren dahingehend verbessert, dass das elektrische Endgerät nach einer der hierin genannten Varianten und Ausführungsformen ausgebildet ist.

Es sei auch noch darauf hingewiesen, dass im Rahmen der hier vorliegenden Patentanmeldung unbestimmte Artikel und unbestimmte Zahlenangaben wie "ein...", "zwei..." usw. im Regelfall als mindestens-Angaben zu verstehen sein sollen, also als "mindestens ein... ", "mindestens zwei..." usw., sofern sich nicht etwa aus dem Kontext oder dem konkreten Text einer bestimmten Stelle ergibt, dass etwa dort nur "genau ein...", "genau zwei..." usw. gemeint sein soll.

An dieser Stelle sei noch erwähnt, dass im Rahmen der hier vorliegenden Patentanmeldung der Ausdruck "insbesondere" immer so zu verstehen ist, dass mit diesem Ausdruck ein optionales, bevorzugtes Merkmal eingeleitet wird. Der Ausdruck ist nicht als "und zwar" und nicht als "nämlich" zu verstehen.

Der große Vorteil diese Lösung besteht darin, dass eine intuitive Bedienung zur werkzeugfreien Änderung der Position und Ausrichtung der (aktiven) Stirnseite des Endgerätes möglich ist. Mittels weniger mechanischer Teile kann eine sehr große Flexibilität erreicht werden. Zudem sind keine separate Halterung, Lagerplatten oder sonstigen losen Teile erforderlich.

Weitere Einzelheiten und Vorteile der Erfindung sollen nun anhand eines in den Zeichnungen dargestellten Ausführungsbeispiels näher erläutert werden.

Es zeigen:
- Fig. 1: eine Ausführungsform als Schnittdarstellung des elektrischen Endgerätes in der Längs- oder Grundausrichtung,
- Fig. 2: die Ausführungsform nach Figur 1 als weitere Schnittdarstellung,
- Fig. 3: die Drehlagereinheit der Figur 1 in einer vergrößerten Detaildarstellung,
- Fig. 4: das Montageelement des Endgerätes gemäß der Figur 1 in einer perspektivischen Darstellung,
- Fig. 5: das Montageelement nach Fig. 4, ergänzt mit einem Grundelement des Endgerätes in einer perspektivischen Darstellung,
- Fig. 6: das Endgerät nach Figur 1 ein zwei Teildarstellungen mit je einer Ausrichtung in perspektivischen Darstellungen,
- Fig. 7: das Endgerät in einer weiteren Ausführungsform aus der Blickrichtung auf die Anschlussseite in perspektivischer Darstellung,
- Fig. 8: das Endgerät in einer weiteren Ausführungsform aus der Blickrichtung auf die Grundseite in perspektivischer Darstellung,
- Fig. 9: das Endgerät in einer weiteren Ausführungsform der für den Verguss relevanten, vertikalen Ausrichtung als perspektivische Darstellung und
- Fig. 10: das Endgerät in einer weiteren Ausführungsform als Schnittdarstellung in einer skizzenhaften Darstellung.

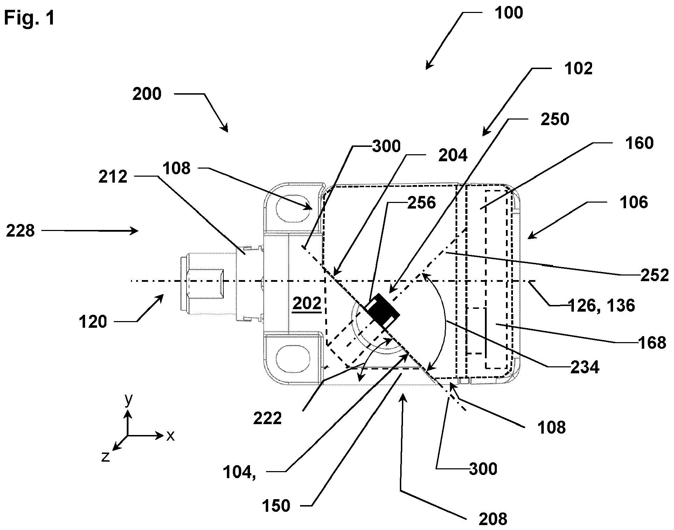

Fig. 1 zeigt einen schematischen Aufbau eines Endgerätes 100, das ein Montageelement 200, Gehäuse 102 mit einem Grundelement 150 und einem Kopfelement 160 aufweist und vorliegend ein induktiver Näherungssensor ist.

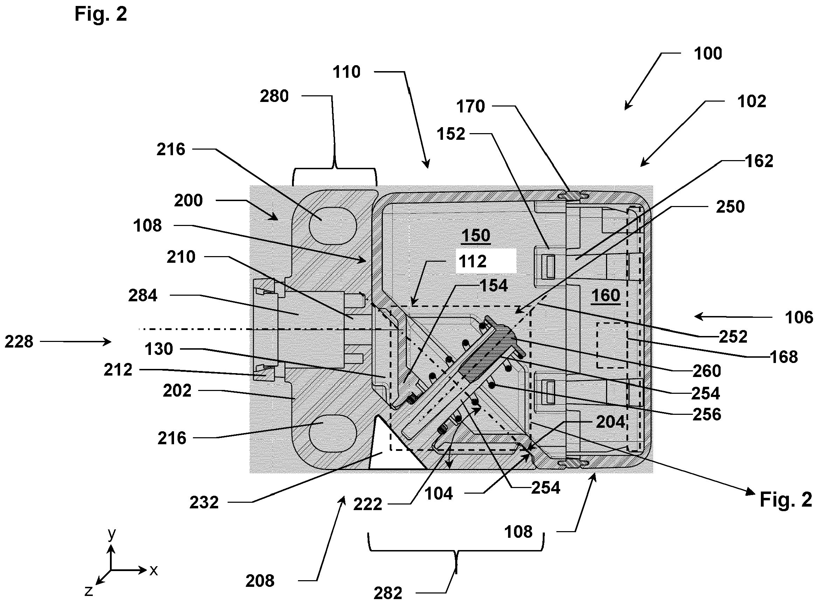

Das elektrische Endgerät 100 ist in der Linear- oder Grundausrichtung gezeigt, in der die Steckerachse 126 in Deckung mit der Hauptachse 136 liegt, wobei die Hauptachse 136 parallel zur x-Achse verläuft, wie mit dem kleinen kartesischen Koordinatensystem angedeutet wurde. Im Kopfelement 160 ist ein elektrisches Bauteil 168 angeordnet, das als gestrichelte Linie angedeutete wurde. Das Montageelement 200 umfasst einen Montagekörper 202, ein Führungselement 212, einen Steckverbinder 120 und eine Auflagefläche 204, wobei weitere Details nachstehend in der Figur 2 gezeigt und ausgeführt sind. Das Grundelement 150 weist zwei Rückseiten 108 auf, von denen eine mit der Grundseite 208 des Montagekörpers 202 eine gemeinsame Unterseite bildet.

Die Auflagefläche 204 des Montagekörpers 202 bildet mit der Fußfläche 104 des Grundelements 150 eine gemeinsame Kontaktebene 300, die zur Bildebene senkrecht steht und als strichpunktierte Linie darstellt ist. Der Neigungswinkel 222 der Kontaktebene 300 und damit auch der Auflagefläche 204 und der Fußfläche 104 beträgt 45°, wie eingezeichnet zur Grundseite 208 und der Hauptachse 136 bzw. der Steckerachse 126.

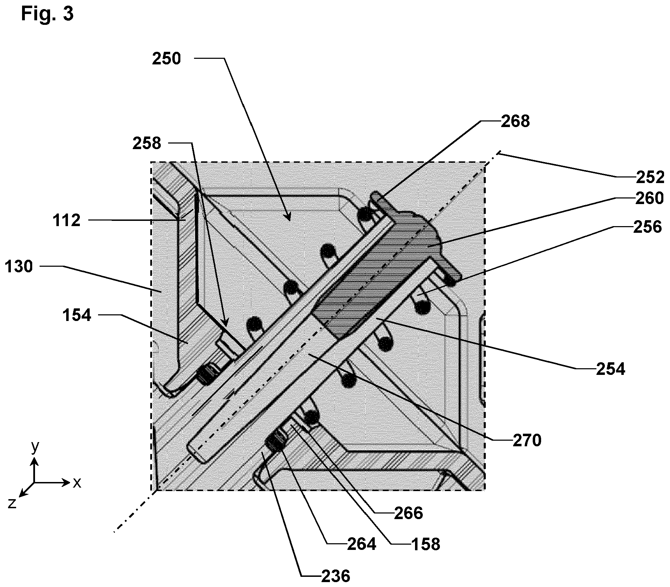

Weiterhin ist eine Drehlagereinheit 250 umfasst, deren Drehachse 252 senkrecht auf der Kontaktebene 300 steht, wie mit dem Winkel 234 dargestellt ist. Die Drehlagereinheit 250 weist ein Federelement 256 auf, das insb. in der Fig. 3 im Detail dargestellt ist. Die Seitenflächen 206 des Montageelements 202 und die Deckenteile 110 des Grundelements 150 sind parallel zur Bildebene und der x-y-Ebene und in der Fig. 1 nicht ausgewiesen.

Das Gehäuse 102 aus dem Grundelement 150 und dem Kopfelement 160 hat im Wesentlichen eine Würfelform mit den Abmessungen von 40x40x40 mm Kantenlänge. Die vorgenannte Kantenlänge ist sehr vorteilhaft in der Automatisierungstechnik, wobei die Kantenlängen hierauf nicht beschränkt sind und beispielsweise im Bereich von 10x10x10 mm bis 100x100x100 mm liegen können.

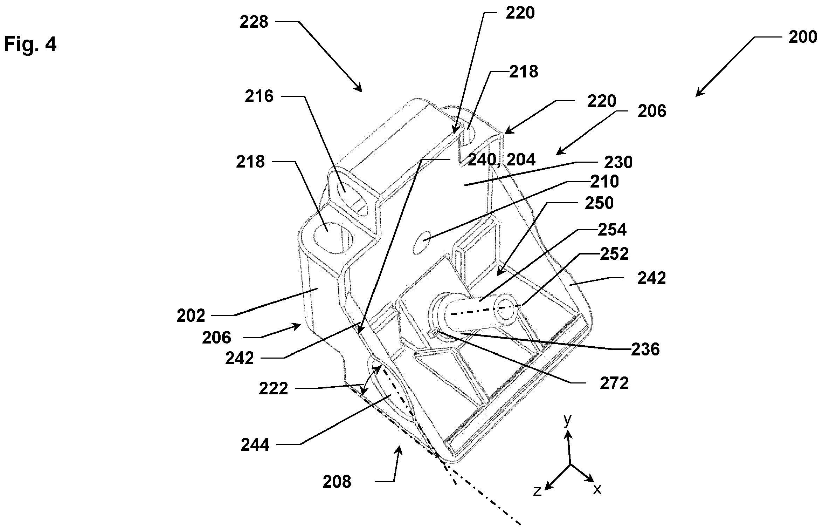

Wie in der Schnittdarstellung der Fig. 2 mit mehr Details zu erkennen, weist der Montagekörper 202 eine Rückwand 280 mit der äußeren Anschlussseite 228 und einem Basisabschnitt 282 mit der Grundseite 208 auf. Die Rückwand 280 und der Basisabschnitt 282 stehen im Wesentlichen senkrecht zueinander. In der Rückwand 280 ist an der Anschlussseite 228 ein Führungselement 212 angeordnet, das in eine Öffnung 284 übergeht und/oder die Öffnung 284 umfasst, die zur Aufnahme eines Adapterköpers oder Steckverbinders (nicht dargestellt) vorgesehen ist. Diese äußere (zweite) Öffnung 284 geht in eine innere (erste) Öffnung 210 mit einem kleineren Durchmesser über und führt in einen Zwischenraum 130, der zwischen dem Montageköper 202 und dem Grundelement 150 bzw. einem Rücksprung in dem Fußelement 112 bzw. dem Drehlagerabschnitt 154 liegt. Weiterhin sind zwei Befestigungselemente 216 umfasst, die als zwei parallele Durchgangsbohrungen ausgebildet sind. Das hierzu senkrecht stehende Paar von zwei weiteren Befestigungselementen 218 ist beispielsweise in der Figur 4 dargestellt.

An dem Übergang von dem Grundelement 150 zum Kopfelemente 160 ist eine umlaufende Doppelringdichtung 170 angeordnet. Das Grundelement 150 und das Kopfelement 160 weisen jeweils eine Gruppe von Kopplungselementen 152, 162 auf. Das Kopplungselement 162 des Kopfelements 160 ist als Rasthaken ausgebildet und das Kopplungselement 152 des Grundelements 150 ist als zugehörige Öse oder Rastkante ausgebildet. Die beiden komplementären Kopplungselemente 152, 162 sind im verbundenen Zustand dargestellt. In dem gezeigten Beispiel sind jeweils zwei komplementäre Kopplungselemente 152, 162 auf jeder Seite angeordnet.

Die Kontaktebene 300 (nicht dargestellt) wird aus der Fußfläche 104 und der aufliegenden Auflagefläche 204 gebildet. Die Fußfläche 104 ist Teil des Fußelements 112, das gemeinsam mit dem oben dargestellten Deckenteil 110, den beiden Rückseiten 108 und den beiden Seitenteilen 114 das Gehäuse des Grundelements 150 bilden. Die Seitenteile 114 stehen senkrecht zu den Rückseiten 108 und die Deckenseite 110 steht senkrecht zu einer Rückseite 108 und ist parallel zu der anderen Rückseite 108.

Das Fußelement 112 weist auf der Unterseite in Teilbereichen die Fußfläche 104 auf und umfasst weiterhin den Drehlagerabschnitt 154. Die Drehlagereinheit 250 umfasst einen Drehlagerbolzen 254, der als Teil des Montagekörpers 202 ausgebildet ist. An dem Fußende des Drehlagerbolzens 254 ist in der Grundseite 208 des Montagekörpers 202 eine Aussparung 232 ausgebildet. Die Auflagefläche 204 und die Fußfläche 104 sind um den Neigungswinkel 222 gegenüber der Grundseite 208 geneigt und die Drehachse 252 steht senkrecht auf diesen und bildet auch die Längsachse des Drehlagerbolzens 254. Außen an dem Drehlagerbolzen 254 ist eine Spiralfeder als Federelement 256 angeordnet, die als Druckfeder über die obere Stützeinheit 260 des Drehlagerbolzens 254 auf den Drehlagerabschnitt 154 des Fußelements 112 und die dortige, untere Stützeinheit 258 wirkt.

In der Detaildarstellung der Fig. 3 ist die Drehlagereinheit 250 der Fig. 1 gezeigt. Das Fußelement 112 geht in dem zentralen Bereich in den Drehlagerabschnitt 154 über, der den Drehlagerbolzen 254 umschließt. Der Drehlagerabschnitt 154 weist einen flanschartigen Lagerabschnitt 158 auf, der in Richtung der Drehachse 252 weist. Auf der Oberseite ist ein metallischer Auflagering 266 angeordnet, auf dem das als Spiralfeder ausgebildete Federelement 256 mit seinem unteren Ende aufsteht und abgleiten kann. In dem freien Ende des Drehlagerbolzens 254 ist ein Stützeinheit 260 angeordnet, die als eine Schraube mit einem äußeren Flanschabschnitt 268 ausgebildet ist. Gegen den Flanschabschnitt 268 liegt das Federelement 256 mit seinem äußeren Ende an. Der Drehlagerbolzen 254 weist einen Innenraum 270 und ein Innengewinde auf, in das die schraubenartige Stützeinheit 260 eingeschraubt ist. Das Federelement 256 wurde durch das Einschrauben der oberen Stützeinheit 260 gestaucht und veranlasst somit eine ständige Vorspannung auf den Lagerabschnitt 158 des Fußelements 112.

Am Fußende des Drehlagerbolzens 254 ist eine umlaufende Auflagekante 236 ausgebildet, auf der das als O-Ring ausgebildete Dichtelement 264 angeordnet ist. Durch die Vorspannung des Federelements 256 wird in der Ruhelage das Dichtelement 264 zwischen dem umlaufenden Lagerabschnitt 158 und der ebenfalls umlaufenden Auflagekante 236 eingepresst und der Innenraum des Grundelements somit abgedichtet. Um die Drehlage des Grundelements 150 zu verändern, wird der Lagerabschnitt 158 von dem Dichtelement 264 abgehoben, entgegen der wirkenden Federkraft, die hierbei erhöht wird. Bei hinreichender Beabstandung in Achsrichtung entfernt von der Ruhelage (Justierlage), kann das Grundelement 150 um die Drehachse geschwenkt werden.

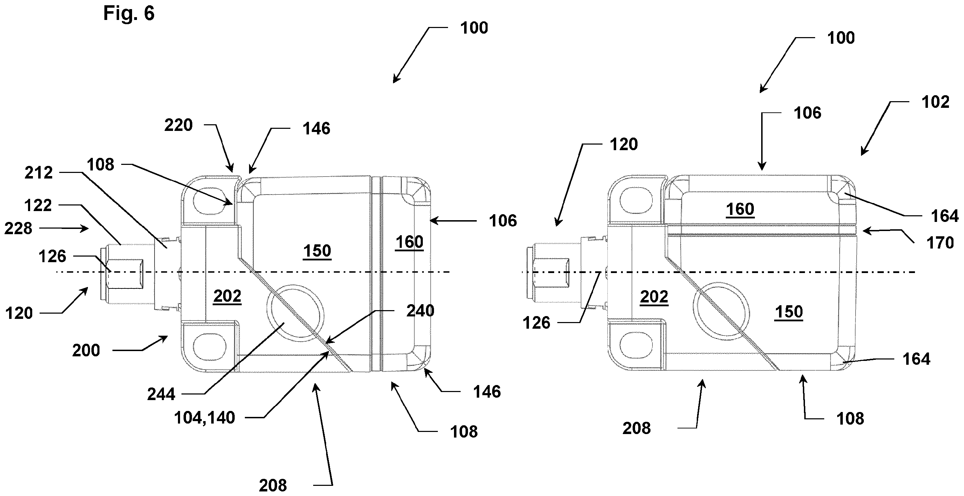

In der Fig. 4 ist der freigestellte Montagekörper 202 gezeigt. Der Montagekörper 202 weist auf dem hinteren Abschnitt die bereits genannten beiden Paare paralleler Befestigungselemente 216, 218 auf, die zueinander senkrecht stehen und deren Achsen eine gemeinsame Ebene aufspannen. In dem gezeigten Ausführungsbeispiel wird die Auflagefläche 204 durch die geneigt verlaufenden Auflagekanten 240 der Seitenflächen 206 und der Grundseite 208 aufgespannt. Parallel zur Auflagekante 240 ist ein Überstand 242 ausgebildet. In der Fig. 6 ist die komplementäre Auflagekante 140 des Grundelements 202 angedeutet.

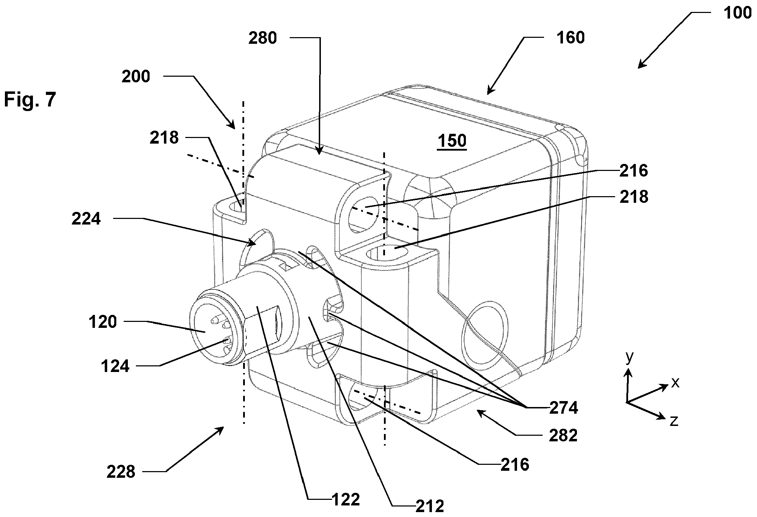

Der Montagekörper 202 weist an dem hinteren Abschnitt auf der Innenseite an den Kanten Sperrkonturen 220 auf, die als überstehende Kanten ausgebildet sind und in Richtung der nicht dargestellten Kanten der Rückseite 108 des Grundelementes 150 ragen. Wie insbesondere in der Fig. 7 gut zu erkennen, verläuft jeweils eine der Sperrkonturen 220 parallel zu einer angrenzenden Kante der Rückseite 108.

Zur Aufnahme eines Befestigungsmittels (nicht dargestellt) und zur Vermeidung einer Überdeckung des ggf. anliegenden LED, ist die Rückwand 280 des Montagekörpers 202 an den zwei oberen Ecken und am Übergang zum Basisabschnitt 282 ausgeschnitten, so dass ein Schraubenkopf das Gehäuse und/oder ein dortiges LED nicht überragt oder verdeckt.

Weiterhin ist in der Fig. 4 im Bereich der unteren Stützeinheit 258 ein Drehanschlag 272 dargestellt, der mit einem entsprechenden Anschlagselement, das am Grundelement angeordnet ist, zusammenwirkt und das Überdrehen und eine Beschädigung des Kabels 132 verhindert.

Weiterhin ist in der Fig. 4 ein aus Festigkeitsgründen vorgesehenes Versteifungselement dargestellt, um eine leichte und materialsparende Bauform zu realisieren.

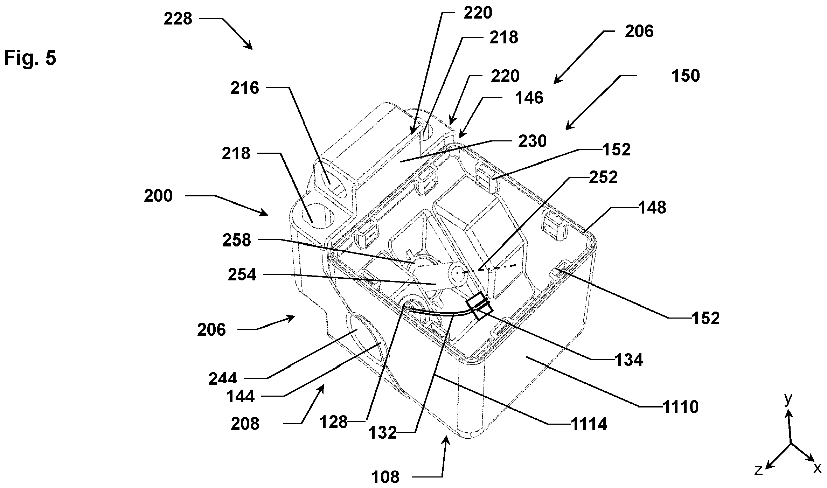

In der Fig. 5 ist das Montageelement 202 nach Fig. 4 ergänzt mit einem Grundelement 150 ohne das Kopfelement 150 dargestellt. Das Grundelement 150 weist neben den bereits beschriebenen Elementen einen Rücksprung auf, in dem eine Durchführung 128 angeordnet ist, durch die das Kabel 132 geführt ist. In dem gezeigten Beispiel ist an dem Kabel 132 bereits ein innerer Steckverbinder 134 befestigt, wobei diese Kabel 132 bzw. dessen Adern an dem elektrischen Bauteil direkt verlötet werden können. Die Durchführung 128 ist eine Öffnung, die ein Dichtung zur fluiddichten Umhüllung des Kabel 132 aufweisen kann. Die Dichtung kann beispielsweise als eine Membrandichtung oder eine Gummilitze ausgebildet sein.

Hinter den Rücksprüngen ist der vorgenannte Zwischenraum zwischen dem Montagekörper 202 und dem Grundelement 150 ausgebildet, in den die Öffnung 210 führt und in dem das Kabel 132 durchgeleitet wird.

Seitlich an dem Montagekörper 202 ist ein erster Teil des Eingriffsfeldes 244 und an dem Grundelement 150 der zweite Teil des Eingriffsfeldes 144 angeordnet. Diese ergeben gemeinsam ein ovales Eingriffsfeld.

Sehr erkennbar sind weiterhin die als Ösen ausgebildeten Kopplungselemente 152 zur Verbindung mit den komplementären Kopplungselementen 162 des Kopfelements 160. Die umlaufende Oberkante 148 weist eine ebenfalls umlaufende Nut für ein Dichtelement 170 auf.

An den Kanten des Montageelements 202 sind im Bereich der an der Innenwand 230 anliegenden Rückseite 108 des Grundelements 202 vorstehenden Sperrkonturen 220 angeformt. Diese überragen die Kanten 146, die zurückspringen und somit die Sperrgegenkontur bilden. Ein zufälliges Verdrehen des Grundelements 150 in der Ruhelage wird somit sicher verhindert. Weiterhin ist zu erkennen, dass ein Teil dieser einen Rückseite 108 von dem noch nicht montierten Kopfelement 160 gebildet wird.

In der Fig. 6 ist das elektrische Endgerät in zwei Teildarstellungen mit je einer Ausrichtung in perspektivischen Darstellungen und in der vollständig montierten, aber nicht befestigten Ausrichtung dargestellt. Die linke Teildarstellung zeigt hierbei die Linearausrichtung oder Grundausrichtung des Endgerätes 100 und die rechte Teildarstellung zeigt die Eckausrichtung, in der das Grundelement 150 mit dem Kopfelement 160 um die Drehachse aus der ersten Ruhelage um 180° verdreht wurde, so dass die zweite Ruhelage erreicht wurde. In dieser zweiten Ruhelage ist das Kopfelement 160 und insbesondere die Kopfseite 106 parallel zur Steckerachse 126 ausgerichtet bzw. steht senkrecht zur Innenwand 230.

In dem Führungselement 212 ist ein Adapterkörper 122 angeordnet, der zur Aufnahme des eigentlichen Steckverbinders zur äußeren Verbindung dient. Das Kopfelement 150 weist an jeder Ecke eine LED 164 auf.

In der Fig. 7 ist das Endgerät aus der Blickrichtung auf die Anschlussseite 228 in Längsausrichtung dargestellt. Rückseitig weist das Montageelement 202 eine Öffnungen 224 auf, die von Stegen 274 unterbrochen werden. Die Stege 274 gehen in das Führungselement 212 über, in dem der Adapterkörper 122 für den Steckverbinder 120 angeordnet ist, von dem drei Kontaktstifte 124 dargestellt sind. Der Adapterkörper 122 ist in das Führungselement 212 in nicht näher dargestellter Weise über zwei Rastelemente eingerastet. Die von dem Führungselement 212 gebildete Öffnung wird durch die Innenwand 230 hindurch und in den Zwischenraum 130 fortgeführt.

Die Öffnungen 224 sind vorliegend nicht durchgängig und werden durch die Innenwand 230 zum Grundelement 150 hin verschlossen.

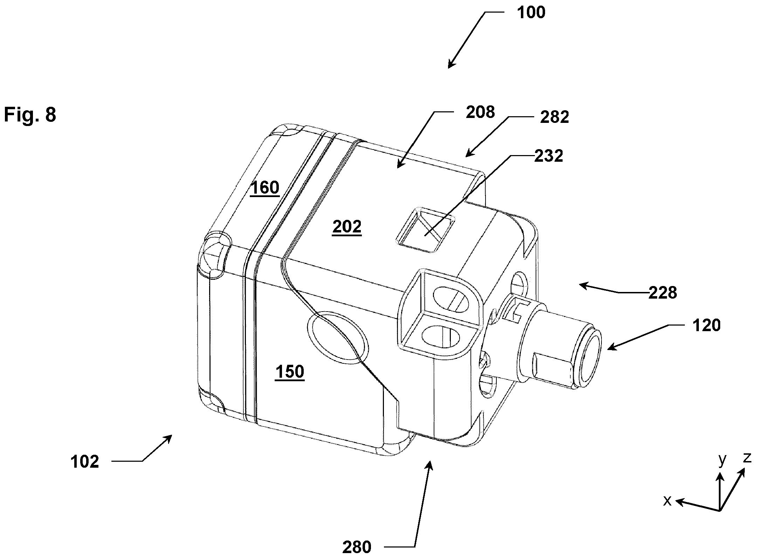

Die Fig. 8 zeigt ebenfalls das Endgerät 100 in einer Längsausrichtung mit dem Blick auf die Grundseite 208. Auf der Grundseite 208 ist eine Aussparung 232 angeordnet, analog zur gezeigten Aussparung der Fig. 2. Hierbei bildet der schräg nach innen verlaufende Wandabschnitt denjenigen Wandabschnitt, auf dem der Drehlagerbolzen 254 mindestens teilweise fußt. Bei einem nicht darstellten Ausführungsbeispiel ist in diesem Wandabschnitt eine Bohrung vorgesehen, so dass eine Schraube von dort oder dort ankommend durch einen hülsenartigen Drehlagerbolzen 254 geführt und somit ein Federelement gehalten und bedarfsweise vorgespannt werden kann.

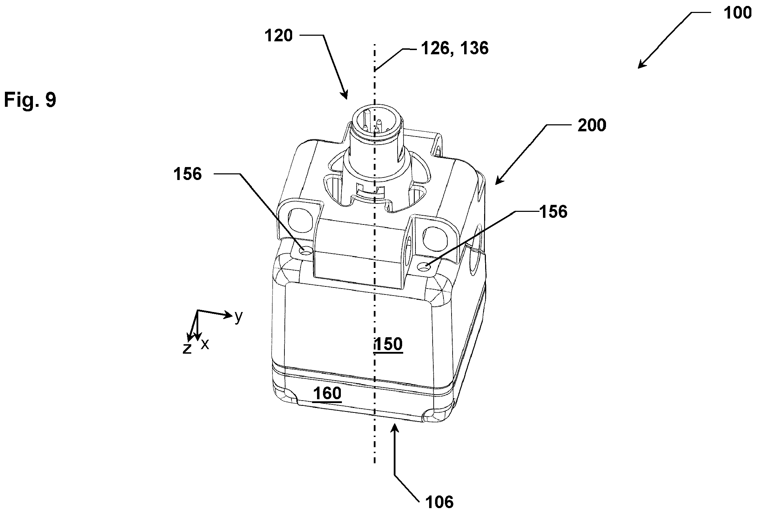

Die Darstellung der Fig. 9 zeigt das das Endgerät 100, das im Bereich der Rückseite 108 zwei Öffnungen 156 aufweist. Diese Öffnungen 156 sind in der Längsausrichtung des Endgerätes 100 derart angeordnet, dass diese im Bereich der Aussparungen auf der Rückseite des Montageelements 202 liegen. Sie sind somit offen und zugänglich, um ein Vergussmaterial von außen einzubringen.

Das Endgerät 100 ist in der Fig. 9 für den Vergussschritt in der bevorzugten Ausrichtung gezeigt, wobei das Kopfelement 160 mit seiner Stirnseite 106 vertikal nach unten ausgerichtet ist. Über eine der beiden Öffnung 156 wird Vergussmaterial eingefüllt, wobei zeitgleich über die zweite Öffnung 156 Luft oder Gas aus dem Innenraum des Gehäuses 102 entweichen kann. Das nicht dargestellte Vergussmaterial wird in den Innenraum soweit eingefüllt, dass die elektrischen Bauteil 168 und der Übergang zwischen dem Kopfelement und dem Grundelement überdeckt sind und/oder soweit, bis die Durchführung 128 für das Kabel 132 und eine dortige Dichtung überdeckt ist.

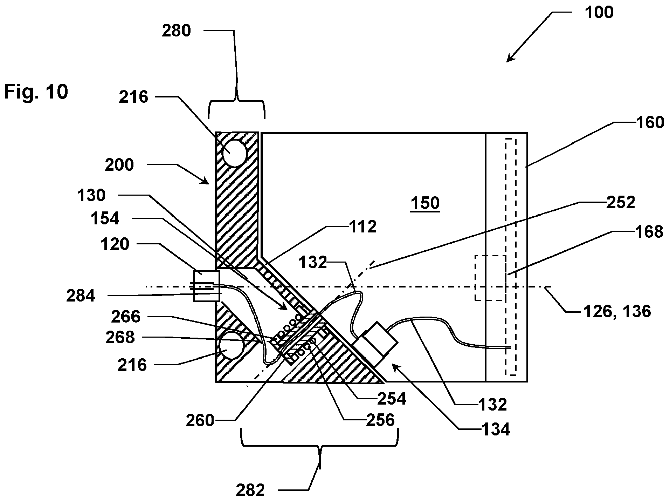

Die Fig. 10 zeigt eine alternative Ausführungsform, die ebenfalls ein Montageelement 200, ein Grundelement 150 und ein Kopfelement 160 umfasst.

Hierbei weist der Montagekörper 202 einen Drehlagerabschnitt 154 auf und ein Drehlagerbolzen 254 ist an dem Grundelement 150 als Teil des Fußelements 112 oder der Fußseite ausgebildet. Die obere Stützeinheit 260 mit einem seitlich überstehenden Flanschabschnitt 268 ist am freien Ende des Drehlagerbolzens 254 angeordnet und kann über die Öffnung oder Aussparung 232 in der Grundseite 208 des Montagekörpers 202 erreicht werden. Der Flanschabschnitt 268 dient als erste Anschlag für das Federelement 256 am einen Ende und ein gegenüberliegender Lagerabschnitt als Element am Montagekörper 202 dienst als zweiter Anschlag, so dass das Federelement 256 ebenfalls als Druckfeder wirkt.

In einer nicht dargestellten Ausführungsform wird das Kabel 132 nicht zentral durch die Drehlagereinheit 250 geführt, wie dargestellt, sondern analog zu den vorherigen Ausführungsformen seitlich in das Grundelement 150 eingeführt. Insbesondere bei dieser Ausführungsform kann der Drehlagerbolzens 254 an seinem freien Ende vollständig dichten verschlossen werden. Weiterhin kann das Kabel 132 ohne inneren Steckverbinder direkt im Bereich des Kopfelementes 160 verlötet werden.

Insgesamt haben vorstehend die Bezugszeichen immer dieselbe Bedeutung und werden zur Vermeidung von Wiederholungen oder Längen nur dann genannt, wenn diese erstmalig auftauchen oder wesentlich für das Verständnis der jeweiligen Abbildung sind. Weiterhin können die einzelnen Merkmale der Ausführungsbeispiele bedarfsweise kombiniert oder ausgetauscht werden, sofern nicht zwingende Gründe dagegensprechen.

### Bezugszeichenliste

- 100: Endgerät, elektrisches
- 102: Gehäuse
- 104: Fußfläche
- 106: Stirnseite
- 108: Rückseite
- 110: Deckenteil
- 112: Fußelement
- 114: Seitenteil

- 120: Steckverbinder
- 122: Adapterkörper
- 124: Kontaktstifte
- 126: Steckerachse
- 128: Durchführung
- 130: Zwischenraum
- 132: Kabel
- 134: Steckverbinder, innerer
- 136: Hauptachse

- 140: Auflagekante
- 144: Eingriffsfeld
- 146: Kante, Sperrgegenkontur
- 148: Oberkante

- 150: Grundelement
- 152: Kopplungselement
- 154: Drehlagerabschnitt
- 156: Öffnung
- 158: Lagerabschnitt
- 160: Kopfelement
- 162: Kopplungselement
- 164: LED

- 168: Bauteil, elektrische
- 170: Dichtelement

- 200: Montageelement
- 202: Montagekörper
- 204: Auflagefläche
- 206: Seiten-/Anlagefläche
- 208: Grundseite
- 210: Öffnung
- 212: Führungselement

- 216: Befestigungselement
- 218: Befestigungselement
- 220: Sperrkontur
- 222: Neigungswinkel der Auflagefläche
- 224: Öffnung

- 228: Anschlussseite
- 230: Innenwand
- 232: Aussparung
- 234: Winkel
- 236: Auflagekante

- 240: Auflagekante
- 242: Überstand
- 244: Eingriffsfeld

- 250: Drehlagereinheit
- 252: Drehachse
- 254: Drehlagerbolzen
- 256: Federelement
- 258: Stützeinheit, untere
- 260: Stützeinheit, obere

- 264: Dichtelement
- 266: Auflagering
- 268: Flanschabschnitt
- 270: Innenraum
- 272: Drehanschlag
- 274: Steg

- 280: Rückwand
- 282: Basisabschnitt
- 284: Öffnung, äußere

- 300: Kontaktebene

## Patentansprüche

1. Elektrisches Endgerät (100), umfassend
- ein mehrseitiges Gehäuse (102) mit
-- einem Grundelement (150), umfassend mindestens zwei Rückseiten (108), und einem Kopfelement (160), welches als Erfassungs- und/oder Funktionselement ausgebildet ist und eine Erfassungs- und/oder Funktionsseite (106) umfasst, und
-- einem Montageelement (200) mit einem Montagekörper (202) mit mindestens zwei Seitenflächen (206), einer Basisseite (208) und einer Innenwand (230), zwei Rückseiten (108), wobei
das Montageelement (200) und/oder der Montagekörper (202) über eine Drehlagereinheit (250), welche eine Drehachse (252) aufweist, mit dem Grundelement (150) verbunden ist, wobei das Grundelement (150) um die Drehachse (252) schwenkbar ist, und
i) das Grundelement (150) eine ein- oder mehrteilige Fußfläche (104) aufweist und
ii) das Montageelement (200) und/oder der Montagekörper (202) eine ein- oder mehrteilige Auflagefläche (204) aufweist, wobei die Fußfläche (104) und die Auflagefläche (204) in einer Ruhelage des Grundelements (150) mindestens mit einer Teilfläche aneinander anliegen und die mindestens eine Teilfläche eine theoretische Kontaktebene (300) aufspannt, die gegenüber der Erfassungs- und/oder Funktionsseite (106) und/oder einer Rückseite (108) um einen Neigungswinkel (222) geneigt ist, insbesondere um einen Neigungswinkel (222) von 45° geneigt ist, und wobei die Drehachse (252) senkrecht zur theoretischen Kontaktebene (300), der Auflagefläche (204) und/oder der Fußfläche (104) ausgerichtet ist, **dadurch gekennzeichnet, dass** das Grundelement (150) aus der Ruhelage in Richtung der Drehachse (252) (parallel) verschieblich und in eine Justierlage verbringbar ist und wobei die Drehlagereinheit (250) ein Federelement (256) umfasst und derart ausgebildet und gelagert ist, dass mittels des Federelements (256) eine Federkraft auf die Fußfläche (104) in Richtung der Anlagefläche (204) und/oder der Kontaktebene (300) wirkt.

2. Elektrisches Endgerät (100) nach Anspruch 1, **dadurch gekennzeichnet, dass** das elektrische Endgerät ein Sensor, ein Emitter oder ein Datenerfassungsgerät ist.

3. Elektrisches Endgerät (100) nach Anspruch 1 oder 2, **dadurch gekennzeichnet, dass** das Federelement (256) eine Feder, ein monolithisches Elastomer oder eine Mehrzahl von elastischen Fasern ist.

4. Elektrisches Endgerät (100) nach einem der vorherigen Ansprüche, **dadurch gekennzeichnet, dass** die Drehlagereinheit (250) mindestens eine (untere) Stützeinheit (258) für das Federelement (256) umfasst.

5. Elektrisches Endgerät (100) nach Anspruch 4, **dadurch gekennzeichnet, dass** die Drehlagereinheit (250) mindestens zwei sich gegenüberliegende Stützeinheiten (258, 260) für das mindestens eine Federelement (256) umfasst.

6. Elektrisches Endgerät (100) nach einem der vorherigen Ansprüche, **dadurch gekennzeichnet, dass** die Drehlagereinheit (250) einen Drehlagerbolzen (254) umfasst, an welchem oder in welchem das mindestens eine Federelement (256) geführt wird.

7. Elektrisches Endgerät (100) nach einem der vorherigen Ansprüche, **dadurch gekennzeichnet, dass** das Montageelement (200) an mindestens einer Seitenfläche (206) und/oder Innenwand (230) mindestens eine Sperrkontur (220) aufweist, welche form- und/oder kraftschlüssig in der Ruhelage (RL) mit einer Sperrgegenkontur (146) des Grundelements (Grundelement) die Verdrehung des Grundelements (Grundelement) um die Drehachse (252) verhindert.

8. Elektrisches Endgerät (100) nach einem der vorherigen Ansprüche, **dadurch gekennzeichnet, dass** der Montagekörper (202) eine erste Öffnung (210) zur Durchführung eines Kabels (132) zum Grundelement (150) und eine weiter Öffnung (284) zur Aufnahme eines Steckverbinders (120) und/oder eines Adapterkörpers (122) für einen Steckverbinder (120) aufweist und wobei die erste Öffnung (210) und die weitere Öffnung (284) ineinander übergehen.

9. Elektrisches Endgerät (100) nach einem der vorherigen Ansprüche, **dadurch gekennzeichnet, dass** das Grundelement (150) und das Kopfelement (160) miteinander verbunden oder verbindbar sind, wobei das Grundelement (150) mindestens ein Kopplungselement (154) umfasst, an welchem ein korrelierendes (Gegen- )Kopplungselement (162) des Kopfelements (160) form- und/oder kraftschlüssig verbindbar ist.

10. Elektrisches Endgerät (100) nach Anspruch 9, **dadurch gekennzeichnet, dass** am Übergang zum Kopfelement (160) ein Dichtelement (170) angeordnet ist.

11. Herstellungsverfahren für ein elektrisches Endgerät (100), **dadurch gekennzeichnet, dass** folgende Schritte umfasst sind:
- Verbinden eines Montageelements (200) mit einem Grundelement (150) an einer gemeinsamen Drehlagereinheit (250), welche eine Drehachse umfasst, **dadurch gekennzeichnet, dass**
- die Drehlagereinheit weiterhin eine Federeinheit umfasst und in einem Schritt
- die Federeinheit entlang der Drehachse derart gespannt wird, so dass das Grundelement (150) auf das Montageelement (160) gepresst wird.

12. Herstellungsverfahren nach Anspruch 11, **dadurch gekennzeichnet, dass** das Kopfelement (160) auf das Grundelement (150) aufgepresst aufgebracht wird.

13. Herstellungsverfahren nach Anspruch 12, **dadurch gekennzeichnet, dass** das elektrische Endgerät (100) derart ausgerichtet wird, dass das Kopfelement (160) und/oder die Stirnseite (106) des Kopfelements (160) vertikal nach unten weist und nachfolgend das Kopfelement (160) durch Öffnungen (156) im Grundelement (150) hindurch mit Vergussmaterial aufgefüllt wird.

14. Herstellungsverfahren nach Anspruch 13, **dadurch gekennzeichnet, dass** das elektrische Endgerät (100) nach einem der Ansprüche 1 bis 10 ausgebildet ist.

15. Verfahren zur Justierung eines elektrischen Endgeräts (100), wobei das elektrische Endgerät ein Grundelement (150) und ein Montageelement (160) umfasst, die sich miteinander in Teilflächen in gegenseitiger Anlage befinden, wobei in einem Justierschritt das Grundelement (150) von einer Ruhelage in einer Linearausrichtung in eine zweite Ruhelagen in einer Eckausrichtung und umgekehrt verbracht wird, **dadurch gekennzeichnet, dass**
die folgenden Schritte umfasst sind:
- das Grundelement (150) wird aus der ersten Ruhelage in Richtung einer Drehachse um eine Strecke gegen eine anliegende Federkraft vom Montageelement (160) abgehoben,
- das Grundelement (150) wird um einen Winkelgrad um die Drehdrehachse (252) gedreht, die der Ausrichtung der zweiten Ruhelage entspricht,
- das Grundelement (150) wird in Richtung der Federkraft und parallel zur Drehachse (254) zurück geführt und mit dem Montageelement (160) in Anlage gebracht.

16. Verfahren nach Anspruch 15, **dadurch gekennzeichnet, dass** das elektrische Endgerät (100) nach einem der Ansprüche 1 bis 10 ausgebildet ist.
